Europäisches Patentamt

European Patent Office

Office européen des brevets

(19)

(11) Veröffentlichungsnummer: **0 334 279**
**A2**

## (12) EUROPÄISCHE PATENTANMELDUNG

(21) Anmeldenummer: 89105007.2

(22) Anmeldetag: 21.03.89

(51) Int. Cl.⁴: **C04B 35/64 , B01J 2/04**

(30) Priorität: 23.03.88 DE 3809694

(43) Veröffentlichungstag der Anmeldung:
27.09.89 Patentblatt 89/39

(84) Benannte Vertragsstaaten:
**DE FR GB**

(71) Anmelder: **Hoechst CeramTec
Aktiengesellschaft
Wilhelmstrasse 14
D-8672 Selb(DE)**

(72) Erfinder: **Grote, Diter
Lärchenweg 6
D-8590 Marktredwitz(DE)**
Erfinder: **Müller, Fritz
Korbersdorf 14
D-8590 Marktredwitz(DE)**

(74) Vertreter: **Spiess, Bernhard et al
Hoechst AG Zentrale Patentabteilung
Postfach 80 03 20
D-6230 Frankfurt am Main 80(DE)**

(54) Keramisches Trennmittel, Verfahren zu seiner Herstellung und seine Verwendung.

(57) Ein Keramisches Material, das unter Brennbedingungen chemisch mit den in der Keramikfolie enthaltenen keramischen Materialien nicht reagiert wird gemeinsam mit einen Lösungsmittel und einem Binder aufgemahlen. Die erhaltene Suspension wird sprühgetrocknet und das Granulat anschließend gebrannt. Zu kleine Teilchen können durch Sieben entfernt werden. Das keramische Material, mit dem das Trennmittel hergestellt wird, ist vorzugsweise Korund, Magnesium/Aluminium-Spinell oder Thoriumoxid.

Das erhaltene Granulat wird beim Stapeln auf keramsiche Grünfolien gestreut, die gebrannt werden sollen. Die gebrannten Substrate haben keine Kratzer und lassen sich leicht trennen.

## Keramisches Trennmittel, Verfahren zu seiner Herstellung und seine Verwendung

Die Anmeldung betrifft ein keramisches Pulver aus kugelförmigen Teilchen, das sich als Trennmittel zum mehrlagigen Brennen von Keramikfolien eignet, ein Verfahren zu seiner Herstellung und seine Verwendung zum mehrlagigen Brennen.

Keramikfolien, beispielsweise $Al_2O_3$-Folien, können durch Gießen von sogenannten Schlickern hergestellt werden. Auf einem Band wird der Schlicker getrocknet und es entsteht eine flexible keramische Folie, die kontinuierlich vom Band abgezogen wird. Eine solche keramische Folie kann mit entsprechend geformten Werkzeugen leicht weiterverarbeitet werden. Anschließend werden die organischen Bestandteile durch Erhitzen aus der Folie verdampft und diese schließlich bei hoher Temperatur zum eigentlichen Substrat gesintert. Dieses allgemeine Herstellungsverfahren von Folienschlicker und die Weiterverarbeitung zu keramischen Gehäusen wird in "Keramische Zeitschrift" 2 1986, S. 79-82 beschrieben. Besonders wirtschaftlich wird ein solches kontinuierliches Verfahren dann, wenn die einzelnen Folien mehrlagig gebrannt werden können. Dieses mehrlagige Brennen stellt jedoch ein Problem dar, da die Folien beim Brennen meist miteinander verkleben und anschließend nicht mehr voneinander getrennt werden können. Um dieses Zusammensintern zu verhindern, bestreut man die einzelnen Folien vor dem mehrlagigen Brennen mit einem Trennmittel, welches nach Möglichkeit nicht oder nur in sehr geringem Ausmaß mit den Folien reagiert. Üblicherweise verwendete Trennmittel sind beispielsweise Korundsand oder Magnesium/Aluminium-Spinellsand. Diese Trennsände werden gewöhnlich durch Mahlen von erschmolzenem Korund bzw. Spinell hergestellt. Jedoch hinterlassen die so hergestellten Trennsände beim mehrlagigen Brennen auf den Substraten Löcher und "Brennkratzer" (Schwindungskratzer), die die Oberflächenqualität drastisch mindern. Diese "Brennkratzer" entstehen allem Anschein nach dadurch, daß sich spitze Körner des Trennsandes in die lederharte Folie eindrücken und dann während des Schwindens der Folie beim Brennen eine rißartige Vertiefung hinterlassen.

Aus diesem Grund werden vor allem solche Substrate, an die sehr hohe Anforderungen an die Oberflächenrauheit gestellt sind, bisher nicht mehrlagig gebrannt.

Der vorliegenden Erfindung lag nun die Aufgabe zugrunde, ein Trennmittel bereitzustellen, das es ermöglicht, Folien mehrlagig zu brennen, ohne daß "Brennkratzer" die Oberflächengüte der Substrate mindern, so daß auch Folien für qualitativ hochwertige Substrate (mit geringem $R_a$) mehrlagig gebrannt werden können.

Diese Aufgabe wird gelöst durch ein Verfahren zur Herstellung eines kugelförmigen keramischen Trennmittels zum mehrlagigen Brennen von Keramikfolien, wobei man ein keramisches Material, das beim Brand chemisch inert gegenüber den in der Keramikfolie enthaltenen keramischen Materialien ist, in Gegenwart eines Lösungsmittels und eines Binders, aufmahlt, die erhaltene Suspension unter gleichzeitigem Trocknen versprüht und das erhaltene Granulat anschließend brennt.

Das auf diese Weise erfindungsgemäß hergestellte Trennmittel besteht aus kleinsten Kügelchen, auf denen die Substrate während des Brennens mehr oder weniger "rollen" können. Dadurch wird verhindert, daß sich einzelne Partikel des Trennmittels in die lederharte Folie eindrücken und dort ihre "Spuren" (Löcher, Brennkratzer) hinterlassen.

Diese Teilchen aus Korund, Thoriumoxid, Zirkonoxid oder Magnesium/Aluminiumspinell haben vorzugsweise eine mittlere Korngröße im Bereich von 30-60 μm. Insbesondere sollten mindestens 90 Gew.-% im Bereich von 10-100 μm liegen. Dies läßt sich z. B. erreichen durch Absieben von Korngrößen, die oberhalb 150 μm oder oberhalb 100 μm liegen.

Die Kugelgestalt der Trennmittelkörner wird durch das Versprühen der Keramiksuspension erreicht. Um ein Zerfallen der Kugeln während des Verdampfens des Lösungsmittels im Sprühturm zu verhindern - und auch um eine genügend hohe Festigkeit der sprühgetrockneten Kügelchen zu erreichen - enthält die Suspension zusätzlich einen Binder, der sich während der Sprühtrocknung nicht oder nur unwesentlich verflüchtigt. Durch das abschließende Brennen der Kügelchen wird die Kugelgestalt "eingefroren" und die Kügelchen ausgehärtet, so daß sie eine genügend hohe Stabilität aufweisen.

Unter einem "keramischen Material, welches chemisch inert gegenüber den in der Keramikfolie enthaltenen keramischen Materialien ist", werden solche Stoffe verstanden, die, in trockener Substanz auf die "grüne Folie" aufgebracht, während des Brennens nicht mit dem keramischen Material der Folie zusammensintern oder durch chemische Reaktionen Stoffumwandlungen an der Oberfläche der Folie hervorrufen. Das Zusammensintern mit der Folie würde zu einem "Verkleben" der Substrate führen und chemische Veränderungen an der Oberfläche der Substrate können beispielsweise zu unterschiedlichen Ausdehnungskoeffizienten führen, so daß sich das Substrat verzieht und Wellen, Risse oder dergleichen aufweist.

Die Auswahl der keramischen Materialien für das Trennmittel richtet sich vor allem nach den keramischen Substanzen der Folien. So sind beispielsweise für Aluminiumoxid- oder Berylliumoxid-Folien, insbesondere Trennmittel aus Magnesium/Aluminium-Spinell ($MgO \bullet Al_2O_3$) aber auch aus Korund, Zirkonoxid und Thoriumoxid geeignet.

Als Lösungsmittel kommen solche in Frage, die bei der Sprühtrocknung möglichst vollständig verdampfen. Geeignet sind beispielsweise Wasser, Methanol, Ethanol und Isobutanol, insbesondere Wasser, aber auch beliebige Mischungen dieser Lösungsmittel.

Der verwendete Binder sollte in dem verwendeten Lösungsmittel löslich sein. Bei Verwendung von Wasser als Lösungsmittel sind beispielsweise geeignet: Polyvinylalkohole oder wasserlösliche Celluloseether. Es können auch beliebige Mischungen der Binder verwendet werden.

Der Binder sorgt dafür, daß die Kugelgestalt der ausgesprühten Suspension erhalten bleibt, wenn das Lösungsmittel verdampft ist.

Bei der Herstellung des Trennmittels geht man am besten so vor, daß man zunächst beispielsweise in einer Trommelmühle ein schmelzgegossenes und vorzerkleinertes keramisches Material, beispielsweise Magnesium/Aluminium-Spinell, mit dem Lösungsmittel versetzt und aufmahlt. Die Mahldauer ist abhängig von der Primärgröße des zerkleinerten keramischen Materials und liegt üblicherweise bei 10 bis 30 Stunden. Die Menge des Lösungsmittels beträgt bevorzugt das 0,5 bis 1,5-fache der eingesetzten Menge des keramischen Materials.

Vorzugsweise wird die Suspension solange aufgemahlen, bis maximal 2 Gew.-% der Teilchen größer sind als 40 $\mu$m und insbesondere der $D_{50}$-Wert der Teilchen im Bereich von 3-20 $\mu$m liegt.

Im Anschluß daran wird der Binder hinzugegeben. Als geeignete Menge haben sich 1 bis 5 Gew.-%, bezogen auf das eingesetzte keramische Material, erwiesen. Gegebenenfalls kann jetzt nochmals eine Zeit lang aufgemahlen werden.

Die so hergestellte Suspension wird nun sprühgetrocknet, wobei übliche Sprühtrockner zur Anwendung kommen, d.h., die Suspension wird mit Hilfe von Düsen oder rotierenden Scheiben zerteilt und in einem Strom eines heißen Gases verfestigt, wobei das Lösungsmittel verdampft. Durch Variation der Sprühbedingungen (beispielsweise Rotationsgeschwindigkeit der Scheibe; Durchmesser der Düsenöffnungen etc.) kann die Tropfengröße beim Versprühen und damit die Größe der Sprühkörner eingestellt werden. Andere Einflußmöglichkeiten sind Verringerung des Feststoffanteils (verringert Korngröße) oder Absieben zu großer Granulatkörner. Bevorzugt sollte der Anteil der Sprühkörner (Granulatkörner) über 120 $\mu$m maximal 5 Gew.-% betragen. Insbesondere sollten mindestens 90 Gew.-% aus den Korngrößen von 50-120 $\mu$m, insbesondere 50-100 $\mu$m, besonders bevorzugt zwischen 80 und 100 $\mu$m liegen.

Diese Sprühkörner werden anschließend in geeignete Gefäße gefüllt (Brennkapsel) und bei Temperaturen von 1200 bis 1400°C, insbesondere 1300°C gebrannt, wodurch sie die nötige Festigkeit erlangen.

Zur Eingrenzung des Korngrößenspektrums werden die getrockneten Sprühkörner auf einen Korngrößenbereich $\leq$ 150 $\mu$m noch besser $\leq$ 120 $\mu$m und $\geq$ 50 $\mu$m, noch besser $\geq$ 80 $\mu$m abgesiebt. Eventuell anfallendes Über- bzw. Unterkorn kann wieder, wie oben beschrieben, aufgemahlen werden. Die Eingrenzung des Korngrößenbereichs hat sich als zweckmäßig erwiesen, da einerseits zu kleine Körner schon erheblich mit den Substraten reagieren können, bzw. auf Grund der minimalen Trennschicht nicht das Zusammensintern der Substrate verhindern und andererseits zu große Körner (Kugeln) in die Substratoberfläche eindringen können und dort Fehler (Schwindungskratzer) erzeugen.

Als besonders vorteilhaft hat es sich erwiesen, wenn der Anteil mit einer Korngröße von 100 bis 150 $\mu$m 2 Gew.-% nicht übersteigt und wenn der Anteil mit einer Korngröße von 70 bis 100 $\mu$m mindestens 90 Gew.-%, vorzugsweise mindestens 97 Gew.-% beträgt (Gew.-%-Angaben beziehen sich auf die Gesamtmasse des Trennmittels).

Die erfindungsgemäßen Trennmittel lassen sich gut zum mehrlagigen Brennen von grünen Keramikfolien einsetzen, die beim Brennen Aluminiumoxid, Zirkonoxid, Aluminiumnitrid, Cordierit oder Berylliumoxid bilden. Hierzu werden die grünen Folien in Lagen von 2 bis 20 in einer Brennkammer übereinandergestapelt und zwischen je zwei Lagen wird eine dünne Schicht von maximal 0,5 mm Dicke eines keramischen Pulvers mit kugelförmigen Teilchen aus Korund, Magnesium/Aluminium-Spinell, Zirkonoxid oder Thoriumoxid, die kleiner sind als 200 $\mu$m, insbesondere kleiner als 150 $\mu$m, aufgestreut. Anschließend wird der Stapel gebrannt.

In dem folgenden Beispiel ist die Erfindung näher erläutert.

## Beispiel

In einer Trommelmühle gefüllt mit 2000 kg Mahlkörpern (Ø 22 mm, $Al_2O_3$ (85%)) werden 1800 kg schmelzgegossener und grob zerkleinerter Magnesium/Aluminium-Spinell (Dynaspinell < 70 $\mu$m) mit 1000 kg Wasser versetzt und 18 Stunden aufgemahlen. Gleichzeitig werden 42 kg Binder (wasserlöslicher Celluloseether und ®Mulrex 575, Lieferant : Mobil Oil AG) hinzugegeben. Die Suspension wird in einem Sprühturm (mit rotierender Scheibe) sprühgetrocknet, die Sprühkörner werden in Brennkapseln gefüllt und bei 1300°C gebrannt. Die verfestigten Sprühkörner werden schließlich auf Kornfraktionen von 70 bis 150 μm abgesiebt.

$Al_2O_3$-Folien für Dickfilmschaltungen wurden mit diesem Trennmittel besandet und 11-lagig bei 1300°C gebrannt. Es traten keine sichtbaren Fehler, insbesondere keine Schwindungskratzer auf. Die Substrate ließen sich leicht voneinander trennen.

**Ansprüche**

1. Verfahren zur Herstellung eines kugelförmigen keramischen Trennmittels zum mehrlagigen Brennen von Keramikfolien, wobei man ein keramisches Material, das im Brand chemisch inert gegenüber den in der Keramikfolie enthaltenen keramischen Materialien ist, in Gegenwart eines Lösungsmittels und eines Binders aufmahlt, die erhaltene Suspension unter gleichzeitigem Trocknen versprüht und anschließend das erhaltene Sprühgranulat brennt.

2. Verfahren nach Anspruch 1, dadurch gekennzeichnet, daß das keramische Material, aus dem das Trennmittel hergestellt wird, Korund, Magnesium/Aluminium-Spinell, Zirkonoxid oder Thoriumoxid ist.

3. Verfahren nach Anspruch 1, dadurch gekennzeichnet, daß das Lösungsmittel Wasser, Methanol. Ethanol oder Isobutanol oder ein Gemisch aus diesen Lösungsmitteln ist.

4. Verfahren nach Anspruch 1, dadurch gekennzeichnet, daß der Binder ein Polyvinylalkohol oder ein Celluloseether ist.

5. Verfahren nach Anspruch 1, dadurch gekennzeichnet, daß die Brenntemperatur zwischen 1200 und 1400°C liegt.

6. Verfahren nach Anspruch 1, dadurch gekennzeichnet, daß aus dem gebrannten Trennmittel Korngrößen ≦ 150 μm durch Absieben isoliert werden.

7. Verfahren nach Anspruch 1, dadurch gekennzeichnet, daß aus dem gebrannten Trennmittel Korngrößen ≦ 100 μm durch Absieben isoliert werden.

8. Verfahren nach Anspruch 1, dadurch gekennzeichnet, daß man durch Einstellen der Sprühparameter und/oder durch Absieben erreicht, daß der Anteil der Granulat-Körner mit Korngrößen über 120 μm maximal 5 Gew.-% beträgt.

9. Verfahren nach Anspruch 8, dadurch gekennzeichnet, daß der Anteil der Granulat-Körner mit Korngrößen von 50-120 μm mindestens 90 Gew.-% beträgt.

10. Verfahren nach Anspruch 1, dadurch gekennzeichnet, daß man die Suspension solange aufmahlt, bis maximal 2 Gew.-% der Teilchen größer sind als 40 μm.

11. Verfahren nach Anspruch 10, dadurch gekennzeichnet, daß man solange mahlt, bis der $D_{50}$-Wert der Teilchen im Bereich von 3-20 μm liegt.

12. Keramisches Trennmittel bestehend aus Korund, Thoriumoxid, Zirkonoxid oder Magnesium/Aluminium-Spinell in Form kugelförmiger Teilchen mit einer mittleren Korngröße im Bereich von 30-60 μm, wobei mindestens 90 Gew.-% im Bereich von 10-100 μm liegen.

13. Verfahren zum mehrlagigen Brennen von grünen Keramikfolien, die beim Brennen Aluminiumoxid, Zirkonoxid, Aluminiumnitrid, Cordierit oder Beryllium oxid bilden, dadurch gekennzeichnet, daß man die grünen Folien in Lagen von 2-20 in einer Brennkammer übereinander stapelt, zwischen je 2 Lagen eine dünne Schicht von maximal 0,5 mm Dicke eines keramischen Pulvers mit kugelförmigen Teilchen aus Korund, Magnesium/Aluminium-Spinell, Zirkonoxid oder Thoriumoxid, die kleiner sind als 200 μm, aufstreut und die grünen Folien brennt.